Europäisches Patentamt

European Patent Office

Office européen des brevets

(11) Publication number: **0 225 678**
**B1**

(12) **EUROPEAN PATENT SPECIFICATION**

(45) Date of publication of patent specification: **14.03.90**

(51) Int. Cl.⁵: **G 03 F 7/26**

(21) Application number: **86202235.7**

(22) Date of filing: **10.12.86**

(54) Apparatus for treating printing plates with a liquid.

(30) Priority: **10.12.85 NL 8503402**

(43) Date of publication of application:
**16.06.87 Bulletin 87/25**

(45) Publication of the grant of the patent:
**14.03.90 Bulletin 90/11**

(84) Designated Contracting States:
**DE FR NL**

(56) References cited:
**FR-A-2 054 129**
**FR-A-2 225 217**
**GB-A-1 212 317**
**US-A-4 004 045**
**US-A-4 213 420**

(73) Proprietor: **Anderson & Vreeland B.V.**
**Kalkovenweg 50**
**NL-2401 LK Alphen a/d Rijn (NL)**

(72) Inventor: **Van der Horst, Hans**
**Molenpad 8**
**NL-2465 AR Rijnsaterwoude (NL)**

(74) Representative: **Hoijtink, Reinoud et al**
**OCTROOIBUREAU ARNOLD & SIEDSMA**
**Sweelinckplein 1**
**NL-2517 GK Den Haag (NL)**

Courier Press, Leamington Spa, England.

## Description

The present invention concerns an apparatus for treating printing plates with a liquid, comprising: a vessel containing the liquid; at least two rotatable brushes submerged at least partially in the liquid; a conveyor provided above the vessel of which the top is open for conveying the printing plates to be treated along the brushes; means for supplying fresh liquid to said vessel; and means for drawing liquid from the vessel.

Such an apparatus is known from US-A-4213420.

In this known apparatus printing plates are treated with a liquid supplied through jets or nozzles. Both jets or nozzles are provided with the same treating liquid, which after dripping of the printing plates to be treated is collected, filtered and used again. By tilting the apparatus a part of the liquid sprayed by the downstream nozzles flows alongside the printing plate against the direction of travel of the plate and is collected by the upstream pan or receptacle. However, only one circuit is provided for the treating fluid, so that the quality thereof steadily decreases as a consequence of the use of the active contents of the liquid. The pollution of the liquid by particles washed out of the plates is filtered out. Consequently, this liquid has to be replaced regularly. As a result thereof the quality of the liquid varies considerably, so that it is possible that the plate to be treated is treated with a liquid which is used considerably. Therefore the quality of the delivered plates varies.

Further, if printing plates are treated in several separated stages, it is of course important, that the last stage uses fresh liquid as this stage determines to a considerable extent the quality of the plates treated, whereas in the more upstream stages the freshness of the liquid is less important.

The aim of the invention is to provide an apparatus for treating printing plates with a liquid, wherein the plates continue to be delivered clean and with a constant quality.

According to the present invention this aim is reached because the vessel is separated into at least two basins by a wall provided in the vessel which wall extends in the direction perpendicular to the direction of movement of the conveyor; means are provided for making the liquid present in one basin move into the adjacent basin in the direction being opposite to the direction of movement of the conveyor; and said means for supplying liquid to the vessel are connected with the upstream basin and said means for drawing liquid from the vessel are connected with the downstream basin.

Further an embodiment of the invention will be described referring to the accompanying drawings. In the drawings are:

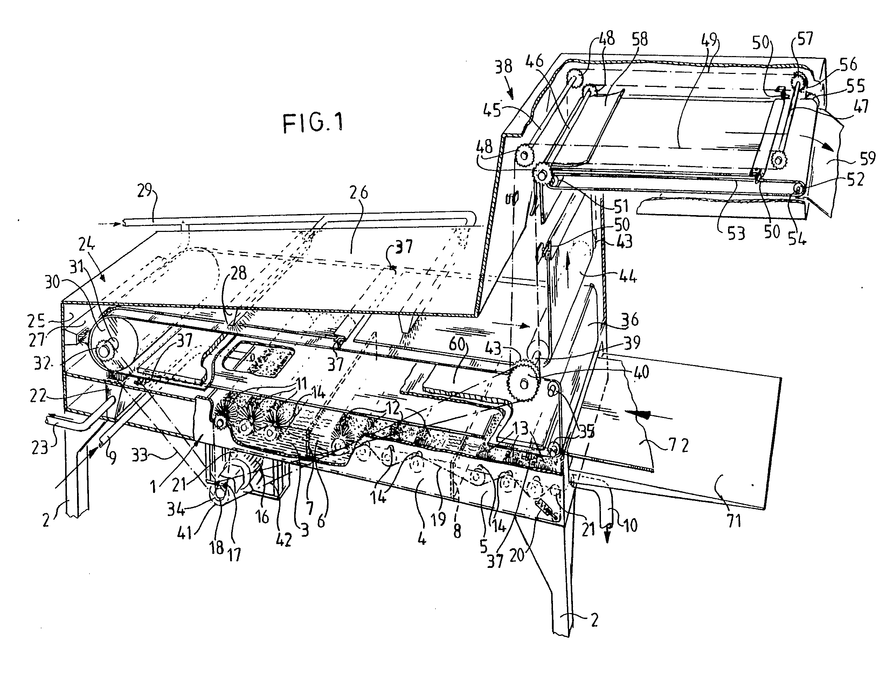

Figure 1: a perspective view partially broken away of an apparatus according to the present invention; and

Figure 2: a perspective view of a clamp used in the apparatus according to the present invention.

The apparatus according to the present invention comprises a tray 1 situated on legs 2. A vessel comprising three basins 3, 4, 5 is applied in the tray, in which basins liquid 6 is contained. The basins are separated mutually by separation walls 7, 8, extending perpendicular to the longitudinal direction of the tray 1, wherein the seperation wall 7 between the first basin 3 and the middle basin 4 is higher than the separation wall 8 between the middle basin 4 and the last basin 5. A supply pipe 9 is connected with the first basin 3, through which supply line liquid is supplied by means of a pump, which is not depicted in the drawings. The liquid thus supplied fills the basin 3 until the liquid flows over the separation wall 7 into the middle basin 4. This basin too is being filled until the liquid flows over the separator wall 8 into the last basin 5. A drainpipe 10 is connected with the last basin 5 through which drainpipe the used liquid is drained from the last basin 5, however a predetermined liquid level is maintained in the last basin 5.

In the first basin 3 is a group of three, in the middle basin is a group of four and in the last basin 5 is a group of three rotatable cylindrical brushes 11, 12, 13 fitted, of which the shaft extends horizontally, perpendicular to the longitudinal direction of the tray 1. Each of the brushes 11, 12, 13 is rigidly fixed on to a shaft 14 rotatably journalled in the tray 1. The mutual distances of the brushes are chosen so that the hairs of adjacent brushes mesh. Under the tray 1 an electric motor 16 is fitted, on the driveshaft 17 of which a sprocket 18 is fixed. A chain 19 is applied around the sprocket 18, zig-zag around each of the sprocket 15 around a chain tension device 20 and around guide wheels 21. Rotation of the electric motor will make any of the brushes 11, 12, 13 rotate and so that adjacent brushes rotate in opposite directions.

Further in the tray is a suction nozzle 22 which extends over the full width of the tray 1 on which suction nozzle 22 a suction pipe 23 is connected.

A cap 24 comprising a head wall 25 and a top wall 26 is provided over the tray 1. Against the inner side of the head wall 25 a nozzle 27 extending over the full width of the cap 24 is provided for spraying warm air, and against the lower side of the top wall 26 two nozzles 28 extending over the full width of the cap 24 are provided for spraying warm air. The nozzles 27, 28 are both connected to a air supply line to supply warm air.

Above the suction nozzle 22 a rotatable drum 30 is provided, of which the shaft is parallel to the shafts of the brushes 11, 12, 13. The shaft 31 of the drum 30 is journalled in side walls of the tray 1 which have been extended in the upper direction. Further a sprocket 32 is fixed on to the shaft 31, around which sprocket a chain 33 is applied, which chain further is applied around a sprocket 34 provided on the drive shaft 17 of the electric motor 16, so that the drum 30 is driven by the electric motor. Two drums 35 are rotatably provided above each other above the last basin 5 on the other side of the tray 1, of which drums the shafts extend parallel to the shaft of the drum 30. An endless belt 36 is applied around the drums 30, 35 and pairs of hooks 37 to be described later are provided on the belt 35, the hooks of each pair being directly opposite each other on the sides of the belt 35. Direct above the lower part of the belt 36 a press plate 60 extending horizontally is provided.

Above the last basin 5 the side walls of the tray 1 are extended in the upward direction so that they form a part of a L-shaped duct 38 which connects with the cap 24 and the tray 1.

Further above the drums 35 a shaft 39 extending perpendicular to the longitudinal direction of the tray 1 is provided. On this shaft 39 a sprocket 40 is provided which is driven through a chain 42 which is applied around the sprocket 40 and a sprocket 41 provided on the drive shaft 17 of the motor 16. On both sides of the belt two sprockets 43 are provided on the shaft 39 and there between a freely rotatable conducting drum 44 is provided. In the bend of the L-shaped duct 38 two shafts 45, 46 and near the end of the duct 38 a shaft 47 are all provided perpendicular to the longitudinal direction of the tray 1. Sprockets 48 are adapted under respective ends of the shafts 45, 46 and 47. Two chains 49 are applied around the sprockets 43 and around the sprockets 48, and on the chain 49 pairs of hooks 50 are provided with equal mutual distances, which will be described afterwards.

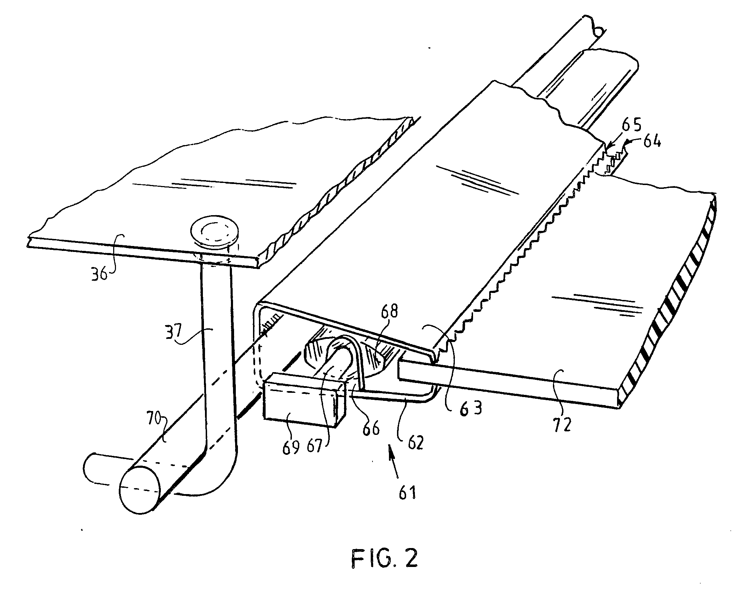

In the horizontal part of the L-shaped duct 38 a belt 53 applied around two drums 51, 52 is provided, in which the drum 52 is fixed rigidly on a shaft 54. Further a sprocket 55 is provided on the shaft 54, which sprocket is driven by means of a chain 56 and a sprocket 57 fixed rigidly on the shaft 47. Further a guide plate 58 is applied near the bend of the L-shaped duct and at the end of the L-shaped duct a guide plate 59 is applied. Subsequently the fixation of the plates to be treated will be described referring to figure 2. A clamp 61 is fixed to the plate 72 to be treated. The clamp 61 comprises a plate of resiliant material bended to form two clamp jaws 62, 63 which are urged resiliantly to each other. The clamp jaws comprise each a row of teeth 64, 65 which engage the plate 72 to be clamped and to be processed. From each end of the clamp jaw 62 a tongue 66 entends to the other clamping jaw. Each of these tongues 66 comprises a hole through which extends à shaft 62. On this shaft 67 a brace 68 is rigidly provided, while on each end of the shaft 67 an operating knob 69 is provided. By turning the operating knob 69 the brace urges the clamping jaws from each other to allow to insert or to remove a plate between the row of teeth 64, 65. Further a shaft 70 extends between the clamping jaws 62, 63 unto both sides of the clamping jaws 62, 63.

Finally the operation of the apparatus according to the present invention will be described.

A printing plate 72 to be treated is clamped between the rows of teeth 64, 65. Then the shaft 70 of the clamp 61 is hooked behind a pair of hooks provided on the belt 36, so that the clamp 61 and the plate 72 to be treated are drawn into the apparatus, wherein the plate 72 is supported by the guide plate 71.

Then the plate 72 is processed by the rotating brushes 13 to a processing by the liquid 6, during which processing the plate 72 is conveyed slowly by the belt 30. By the pressure exerted by the brushes 13 to the plate 72 the plate 72 is pressed against the belt and against the pressing plate 60. The plate 72 is further being conveyed alongside the brushes 12 in a basin 4 and subsequently along the brushes 11 in the basin 3. By supplying fresh processing liquid to the basin 3 the processing executed by the brushes 11 in the basin 3 continues to take place with clean liquid, so that the last washing process of the plate takes place with clean liquid. The liquid considerably polluted and used in the first basin is supplied to the middle basin 4, where the plates 72 are being adapted to a first processing. From the middle basin 4 the liquid which increases to be polluted is supplied to the last basin 5, where the plates are being subjected to a first washing treatment.

After the washing treatment the plate 72 is conveyed along the suction nozzle 22, where the liquid adhering to the plate 72 is being sucked off.

The belt 30 then leads the plate 72 along three consecutive nozzles which spray warm air to the plate 30 to dry the plate 72.

Caused by a slightly faster speed of the chains 49 than that of the belt 36 the hooks 50 provided on the chains 49 engage the shaft 70 of the clamp 61 and remove this from the hooks 37 provided on the belt 36. Thus the clamp 61 with the plate 72 arranged therein is conveyed into the L-shaped duct 38 by the conducting hooks 50 fixed on the chains 49, after which the plate to be treated returns to a horizontal movement and gets to rest on the belt 53. Because the chains 49 move slightly faster than the belt 53 the shaft 70 is being removed from the hooks 50 and the clamp will rest on the belt 53 as well. In the proximity of the belt 53 a (not depicted) heating element can be provided to cause a last drying of the plate. The belt 53 moves the plate outwardly until the guide plate 59 where the plate 72 can be grasped and the clamp 60 can be removed from the plate.

## Claims

1. Apparatus for treating printing plates with a liquid (6), comprising:

a vessel of which the top is open containing the liquid (6);

at least two rotatable brushes (11, 12, 13) submerged at least partially in the liquid (6);

a conveyor (36) provided above the vessel (3, 4, 5) for conveying the printing plates (72) to be treated along the brushes (11, 12, 13);

means (9) for supplying fresh liquid (6) to said vessel (3, 4, 5); and

means (10) for drawing liquid from the vessel, characterized in that the vessel is separated into at least two basins (3, 4, 5) by a wall (7, 8) provided in the vessel which wall (7, 8) extends in the direction perpendicular to the direction of movement of the conveyor (36);

that means (7, 8) are provided for making the liquid present in one basin (3, 4, 5) move into the adjacent basin in the direction being opposite to the direction of movement of the conveyor (35); and

that said means (9) for supplying liquid to the vessel are connected with the upstream basin (3) and said means (10) for drawing liquid from the vessel (3, 4, 5) are connected with the downstream basin (5).

2. Apparatus according to claim 1, characterized in that the height of the walls (7, 8) provided in the vessel decreases in the direction, being opposite to the direction of movement of the conveyor (36).

3. Apparatus according to claim 1 or 2, characterized in that at least two brushes (11, 12, 13) are provided in each basin (3, 4, 5) of which the direction of rotation is opposite to each other.

4. Apparatus according to claim 3, characterized in that the brush hairs of adjacent brushes (11, 12, 13) mesh.

5. Apparatus according to one of the preceding claims, characterized in that the brushes (11, 12, 13) oscillate in the direction being perpendicular to the direction of movement of the conveyor (36).

6. Apparatus according to one of the preceding claims, characterized in that the direction of movement of the conveyor (36) downstream of the vessel a (3, 4, 5) a suction apparatus (22, 23) has been provided.

7. Apparatus according to claim 6, characterized in that downstream of the suction apparatus (22, 23) a dryer (27, 28, 29) using warm air has been provided.

8. Apparatus according to claim 7, characterized in that the dryer (27, 28, 29) using warm air comprises at least one nozzle (27, 28) for spraying warm air.

9. Apparatus according to claim 8, characterized in that two nozzles (27, 28) are provided above the belt (36).

10. Apparatus according to one of the preceding claims, characterized in that a further conveyor (45-50) has been provided for conveying the plates to be treated to an after dryer.

11. Apparatus according to one of the preceding claims, characterized in that the conveyor (36) is a belt conveyor.

12. Apparatus according to claim 10 or 11, characterized in that the further conveyor (45-50) comprises two conveying chains (49).

13. Apparatus according to claim 12, characterized in that the belt conveyor (36) and the conveyor chain (49) both comprise hooks (50) fixed on equal distances.

14. Apparatus according to claim 13, characterized in that the plates (72) to be treated are engaged by clamps (61) engageable by the hooks (50).

15. Apparatus according to claim 14, characterized in that the clamps (61) comprise a shaft (6) engageable with the hooks, which shaft (67) extends through a plate bended unto two clamping jaws (62, 63).

16. Apparatus according to claim 15, characterized in that the clamps (61) comprise a brace (68) extending through the plate forming the clamping jaws (62, 63), which brace (68) comprises at least one handle (69).

## Patentansprüche

1. Vorrichtung zur Behandlung von Druckplatten mit einer Flüssigkeit (6), welche folgende Teile umfaßt:

ein oben offenes Gefäß, welches die Flüssigkeit (6) enthält:

wenigstens zwei drehbare Bürsten (11, 12, 13), die wenigstens teilweise in die Flüssigkeit (6) eintauchen;

eine Fördervorrichtung (36) über dem Gefäß (3, 4, 5), welche die zu behandelnden Druckplatten (72) längs der Bürsten (11, 12, 13) entlangführt;

Mittel (9), um das Gefäß (3, 4, 5) mit frischer Flüssigkeit (6) zu versorgen; und

Mittel (10) zum Abziehen von Flüssigkeit aus dem Gefäß, dadurch gekennzeichnet,

daß das Gefäß in wenigstens zwei Tröge (3, 4, 5) durch eine Wand (7, 8) unterteilt ist, die im Gefäß angeordnet ist und sich in Richtung senkrecht zur Bewegungsrichtung der Fördervorrichtung (36) erstreckt;

daß Mittel (7, 8) vorgesehen sind, welche die in einem Trog (3, 4, 5) vorhandene Flüssigkeit in den benachbarten Trog in einer Richtung bewegen, die der Bewegungsrichtung der Fördervorrichtung (35) entgegengesetzt ist; und

daß die Mittel (9) zur Zuführung von Flüssigkeit nach dem Gefäß mit dem stromaufwärtigen Trog (3) verbunden sind und die Mittel (10) zum Abziehen der Flüssigkeit aus dem Gefäß (3, 4, 5) mit dem stromabwärtigen Trog (5) verbunden sind.

2. Vorrichtung nach Anspruch 1, dadurch gekennzeichnet, daß die Höhe der Wände (7, 8) in dem Gefäß in Richtung entgegengesetzt zur Bewegungsrichtung der Fördervorrichtung (36) abnimmt.

3. Vorrichtung nach den Ansprüchen 1 oder 2, dadurch gekennzeichnet, daß wenigstens zwei Bürsten (11, 12, 13) in jedem Trog (3, 4, 5) vorgesehen sind, deren Drehrichtung entgegengesetzt zueinaner verläuft.

4. Vorrichtung nach Anspruch 3, dadurch gekennzeichnet, daß die Borsten benachbarter Bürsten (11, 12, 13) ineinandergreifen.

5. Vorrichtung nach einem der vorhergehenden Ansprüche, dadurch gekennzeichnet, daß die Bürsten (11, 12, 13) in Richtung senkrecht zur Bewegungsrichtung der Fördervorrichtung (36) oszillieren.

6. Vorrichtung nach einem der vorhergehenden Ansprüche, dadurch gekennzeichnet, daß in Bewegungsrichtung der Fördervorrichtung (36) stromab des Gefäßes (3, 4, 5) eine Saugvorrichtung (22, 23) vorgesehen ist.

7. Vorrichtung nach Anspruch 6, dadurch gekennzeichnet, daß stromab der Saugvorrichtung (22, 23) ein Trockner (27, 28, 29) vorgesehen ist, welcher Warmluft benutzt.

8. Vorrichtung nach Anspruch 7, dadurch gekennzeichnet, daß der Trockner (27, 28, 29), der Warmluft benutzt, wenigstens eine Düse (27, 28) aufweist, um Warmluft auszublasen.

9. Vorrichtung nach Anspruch 8, dadurch gekennzeichnet, daß zwei Düsen (27, 28) über dem Förderriemen (36) angeordnet sind.

10. Vorrichtung nach einem der vorhergehenden Ansprüche, dadurch gekennzeichnet, daß eine weitere Fördervorrichtung (45-50) vorgesehen ist, um die zu behandelnden Platten einem Nachtrockner zuzuführen.

11. Vorrichtung nach einem der vorhergehenden Ansprüche, dadurch gekennzeichnet, daß die Fördervorrichtung (36) ein Förderriemen ist.

12. Vorrichtung nach den Ansprüchen 10 oder 11, dadurch gekennzeichnet, daß die weitere Fördervorrichtung (45-50) zwei Förderketten (49) aufweist.

13. Vorrichtung nach Anspruch 12, dadurch gekennzeichnet, daß der Förderriemen (36) und die Förderkette (49) beide in gleichem Abstand angeordnete Haken (50) aufweisen.

14. Vorrichtung nach Anspruch 13, dadurch gekennzeichnet, daß die zu behandelnden Platten (72) von Klemmen (61) erfaßt werden, die ihrerseits durch die Haken (50) beaufschlagt werden.

15. Vorrichtung nach Anspruch 14, dadurch gekennzeichnet, daß die Klemmen (61) eine Welle (67) aufweisen, die mit den Haken zusammenwirkt, wobei die Welle (67) sich durch eine Platte hindurch erstreckt, die zu zwei Klemmbacken (62, 63) abgebogen ist.

16. Vorrichtung nach Anspruch 15, dadurch gekennzeichnet, daß die Klemmen (61) einen Spreizkörper (68) aufweisen, der durch die die Klemmbacken (62, 63) bildende Platte hindurchsteht, wobei der Spreizkörper (68) wenigstens einen Handgriff (69) besitzt.

**Revendications**

1. Appareil pour le traitement des plaques d'impression par un liquide (6), comprenant:

une cuve à dessus ouvert contenant le liquide (6);

au moins deux brosses tournantes (11, 12, 13) immergées au moins partiellement dans le liquide (6);

un convoyeur (36) installé au-dessus de la cuve (3, 4, 5) pour acheminer les plaques d'impression (72) à traiter le long des brosses (11, 12, 13);

des moyens (9) pour introduire du liquide neuf (6) dans ladite cuve (3, 4, 5); et

des moyens (10) pour retirer le liquide de la cuve, caractérisé en ce que

la cuve est séparée en au moins deux bassins (3, 4, 5) par une cloison (7, 8) installée dans la cuve, laquelle cloison (7, 8) est orientée perpendiculairement à la direction du mouvement du convoyeur (36);

des moyens (7, 8) sont prévus pour déplacer le liquide contenu dans un bassin (3, 4, 5) vers le bassin adjacent dans la direction opposée à la direction du mouvement du convoyeur (35); et

lesdits moyens (9) pour introduire du liquide dans la cuve sont connectés au bassin amont (3) et en ce que lesdits moyens (10) pour retirer le liquide de la cuve (3, 4, 5) sont connectés au bassin aval (5).

2. Appareil selon la revendication 1, caractérisé en ce que la hauteur des cloisons (7, 8) installées dans la cuve diminue dans la direction opposée à la direction du mouvement du convoyeur (36).

3. Appareil selon la revendication 1 ou la revendication 2, caractérisé en ce qu'il y a au moins deux brosses (11, 12, 13) installées dans chaque bassin (3, 4, 5) dont les directions de rotation sont opposées.

4. Appareil selon la revendication 3, caractérisé en ce que les poils de brosse des brosses adjacentes (11, 12, 13) s'engrènent.

5. Appareil selon l'une des revendications précédentes, caractérisé en ce que les brosses (11, 12, 13) oscillent dans la direction perpendiculaire à la direction du mouvement du convoyeur (36).

6. Appareil selon l'une des revendications précédentes, caractérisé en ce que dans la direction du mouvement du convoyeur (36) en aval de la cuve (3, 4, 5) est installé un dispositif d'aspiration (22, 23).

7. Appareil selon la revendication 6, caractérisé en ce qu'en avail du dispositif d'aspiration (22, 23) est installé un séchoir à air chaud (27, 28, 29).

8. Appareil selon la revendication 7, caractérisé en ce que le séchoir (27, 28, 29) utilisant de l'air chaud comporte au moins une buse (27, 28) pour projeter de l'air chaud.

9. Appareil selon la revendication 8, caractérisé en ce que deux buses (27, 28) sont installées au-dessus de la courroie (36).

10. Appareil selon l'une des revendications précédentes, caractérisé en ce qu'un autre convoyeur (45-50) est installé pour acheminer les plaques à traiter vers le séchoir ou à partir du séchoir.

11. Appareil selon l'une des revendications précédentes, caractérisé en ce que le convoyeur (36) est un convoyeur à bande.

12. Appareil selon l'une des revendications 10 ou 11, caractérisé en ce que le second convoyeur (45-50) comprend deux chaînes convoyeuses (49).

13. Appareil selon la revendication 12, caractérisé en ce que le convoyeur à bande (36) et les chaînes convoyeuses (49) comprennent tous deux des crochets (50) fixés à intervalles égaux.

14. Appareil selon la revendication 13, caractérisé en ce que les plaques (72) à traiter sont prises par des pinces (61) susceptibles de coopérer avec les crochets (50).

15. Appareil selon la revendication 14, caractérisé en ce que les pinces (61) comprennent un arbre (67) susceptible de coopérer avec les crochets, lequel arbre (67) traverse une plaque coudée en formant deux pinces de serrage (62, 63).

16. Appareil selon la revendication 15, caractérisé en ce que les pinces (61) comprennent une flasque (68) s'étendant à travers la plaque constituant les mâchoires de serrage (62, 63), laquelle flasque (68) comprend au moins une poignée (69).

FIG.1

EP 0 225 678 B1

FIG. 2